Europäisches Patentamt

European Patent Office

Office européen des brevets

(19)

(11) **EP 1 408 420 A1**

(12) **EUROPEAN PATENT APPLICATION**
published in accordance with Art. 158(3) EPC

(43) Date of publication:
**14.04.2004 Bulletin 2004/16**

(51) Int Cl.⁷: **G06F 17/13**, G06F 15/16,
G06F 17/50, G01M 19/00

(21) Application number: **02769580.8**

(22) Date of filing: **13.05.2002**

(86) International application number:
**PCT/JP2002/004617**

(87) International publication number:
**WO 2002/093412 (21.11.2002 Gazette 2002/47)**

(84) Designated Contracting States:
**AT BE CH CY DE DK ES FI FR GB GR IE IT LI LU
MC NL PT SE TR**

(30) Priority: **14.05.2001 JP 2001142949**

(71) Applicants:
• **Allied Engineering Corporation
Shinagawa-ku, Tokyo 140-0014 (JP)**
• **JAPAN SCIENCE AND TECHNOLOGY
CORPORATION
Kawaguchi-shi, Saitama 332-0012 (JP)**
• **Suzuki, Masabumi
Tokyo 140-0014 (JP)**

(72) Inventors:
• **AKIBA, Hiroshi
c/o, Allied Engineering Corporation
Shinagawa-ku, Tokyo 140-0014 (JP)**
• **OHYAMA, Tomonobu
Allied Engineering Corporation
Shinagawa-ku, Tokyo 140-0014 (JP)**
• **SUZUKI, Masabumi
Allied Engineering Corporation
Shinagawa-ku, Tokyo 140-0014 (JP)**

(74) Representative: **Leeming, John Gerard
J.A. Kemp & Co.,
14 South Square,
Gray's Inn
London WC1R 5JJ (GB)**

(54) **PARALLEL INFINITE ELEMENT METHOD CALCULATION SYSTEM**

(57)   The well known methods for a very large scaled structure problem, including domain decomposition method (DDM), DDM with Neumann preprocessing, BDD method and projected CG method, may involve problems that the divergence prevents from solving, and that the computation takes long time. The present invention provides a system of high potential computing performance for solving a very large scaled structure problem without divergence, with shorter computing time for a very large scaled structure problem of the degree of freedom of a million or more.

The present invention comprises a parallel finite element method computing system for solving a very large scaled structure problem having the degree of freedom of one million (1,000,000) or more, comprising: a means for performing domain decomposition; a means for distributing a subdomain to a responsible part of each processor; a means for creating a rigid matrix; a means for defining overlapped movement of entire subdomain; a means for defining a default setting of projected CG method with preprocessing of all degree of freedom; a means for performing iterative computation of proj ected CG method with preprocessing of all degree of freedom; and a means for outputting a displacement solution, and a program for operating said system, and a computer readable recording medium having said program stored thereon.

Fig. 2

**Description**

BACKGROUND OF THE INVENTION

Field of the Invention:

The present invention relates to a very large scale parallel finite element method solver algorithm, which may effectively solve a very large scale structure problem of the degree of freedom of more than a million (1,000,000). More particularly, the algorithm incorporates a conjugate projected gradient algorithm of the domain decomposition, based on a parallel CG algorithm. The algorithm may be referred to as a "CGCG method (coarse Grid CG method)". A space of the degree of freedom of subdomain level by the domain decomposition is referred to as a coarse space, and the subspace perpendicular to K is referred to as a fine space, where a stiffness matrix of the given structure problem is defined as K. The CGCG method may perform in parallel the conjugate projected gradient algorithm, adopting the k-orthogonal projection to the fine space for the projection.

Description of the Prior Art:

The structural problem may be in general treated as follows: The objective structure in question is formulated as a continuum to define the dynamic equation of the continuum ( equalizing equation in case of a static problem). It is almost impossible to solve this equation strictly. Rather the equation must be solved in such a manner as the numerical analysis. For this reason a reformulation of discrete proximity of the continuum problem is required. One of the solution proposed is the finite element method (computational dynamics handbook (I): finite element method for the structure, Japan Society of Mechanical Engineers, 1998). In the finite element method the space occupied by the continuum is at first decomposed to a plurality of elements (elements of the finite element method). Functions (form functions) having a domain with non-zero value localized to each element is then introduced to proximate to limit the continuum displacement field to expressions of the convolution of these functions. This may result in digitizing of the continuum displacement field and its motion equation (or equalizing equation). The digitizing allows the equation to decompose to a single linear equation (in case of a static linear problem) or a plurality of linear equations (for each incremental step in case of a non-linear problem; for each time step in case of dynamic problem). The degree of freedom (or dimension) treated by the linear equation is depending on the number of division of elemental decomposition of the continuous domain by the finite element method; the degree of freedom increases in general with the increase of the number of decomposition for better proximity, causing the difficulty of solving the corresponding linear equation.
The static structural problem of micro deformation may be decomposed to a linear problem on a product vector space in a finite dimension V given by the following equation (1)

$$\text{eq 1} \quad Ku = F$$

where V designates to a space of permissible displacement field (vector field satisfying the boundary conditions of the displacement field), K to a stiffness matrix of the dimension dimV of V (symmetric when positive fixed set point), **u** to a variable vector of V, **F** to a constant vector of the KV ≈ V indicative of external force. The dimension dimV of V is equal to the number of the degree of freedom of the problem. The objective of the solver is to find a vector **u** , which satisfies the equation (1) above from within V.
Now the conjugate projected gradient algorithm (CPG: Conjugate Projected Gradient Algorithm: C. Farhat, F. X. Roux: Implicit Parallel Processing in Structural Mechanics, Computational Mechanics Advances 2, 1-124, 1994) will be described, which constitutes the base of the present invention. Consider a generic liner equation (eq. 2) of an inner product,vector space V in a finite dimension:

$$\text{eq 2} \quad Ku = F, \qquad u, F \in V$$

where K is a linear transform of positive constant symmetry. One subspace Y of V is then selected. V is K-orthogonally projected to Y. A unique K-orthogonal projector $\mathbf{P}^{(Y)}$, $\mathbf{K}\mathbf{P}^{(Y)}=\mathbf{P}^{(Y)T}\mathbf{K}$ is determined. $\mathbf{P}^{(Y)T}$ is the transposition of $\mathbf{P}^{(Y)}$. At this point a K-orthogonal projector $\mathbf{P}^{(a)}$ (auxiliary projector of $\mathbf{P}^{(Y)}$, $\mathbf{K}\mathbf{P}^{(a)} = \mathbf{P}^{(a)T}\mathbf{K}$ is uniquely determined, which satisfies the condition $\mathbf{P}^{(Y)} + \mathbf{P}^{(a)} =1$, the entire space V may be k-orthogonal direct sum decomposed to the image space Y, $\mathbf{V}^{(a)}$ of the $\mathbf{P}^{(Y)}$ and $\mathbf{P}^{(a)}$, as given by equation (3) :

$$eq\ 3\ \ V = Y \oplus V^{(a)}, \qquad Y \perp_K V^{(a)}, \qquad \begin{pmatrix} Y \\ V^{(a)} \end{pmatrix} = \begin{pmatrix} P^{(Y)} \\ P^{(a)} \end{pmatrix} V$$

The K-orthogonality of $P^{(Y)T} P^{(Y)}$ and $P^{(a)}$ can be summarized as equation (4) :

$$eq\ 4\ \ K \begin{pmatrix} P^{(Y)} \\ P^{(a)} \end{pmatrix} = \begin{pmatrix} P^{(Y)T} \\ P^{(a)T} \end{pmatrix} K$$

Therefore the linear equation eq. (2) can be decomposed to equation (5) :

$$eq\ 5\ \ K \begin{pmatrix} P^{(Y)} \\ P^{(a)} \end{pmatrix} u = \begin{pmatrix} P^{(Y)T} \\ P^{(a)T} \end{pmatrix} F$$

Now the KY-component of $F$, $P^{(Y)T}F$ and $KV^{(a)}$-component, $P^{(a)T}$ , or Y-component of $u$, $P^{(Y)}u$ and $V^{(a)}$-component $P^{(a)}u$ maybe independently processed. In brief, equation (2) can be K-orthogonally direct sum decomposed to two independent equations (6) and (7) with equation (8). For the sake of convenience, $Y$ is referred to as direct space, $V^{(a)}$ that is k-orthogonal auxiliary space of Y is referred to as iterative space.

$$eq\ 6\ \ Ku^{(Y)} = F_{(Y)}, \qquad u^{(Y)} \in Y, \qquad F_{(Y)} \in KY$$

$$eq\ 7\ \ Ku^{(a)} = F_{(a)}, \qquad u^{(a)} \in V^{(a)}, \qquad F_{(a)} \in KV^{(a)}$$

$$eq\ 8\ \ u = u^{(a)} + u^{(Y)}, \qquad F = F_{(a)} + F_{(Y)}$$

Now consider that a subspace $W$ of the direct space $Y$ is specially determined. This W is referred to as coarse space, herein below. The K-orthogonal auxiliary space of $W$ is referred to as a fine space. When $Y$ is K-orthogonal direct sum decomposed to $W$ and $W^c$, the K-orthogonal auxiliary space of $W$, equation (9) on $W$ may be set in a manner similar to equation (6) as follows :

$$eq\ 9\ \ u^{(W)} \in W : Ku^{(W)} = F_{(W)}, \qquad F_{(W)} \equiv P^{(W)T} F \in P^{(W)T} V = KW$$

where $P^{(W)}$ designates to the k-orthogonal projector to W. This equation is referred to as the coarse grid problem. If W is defined by setting its base

$$\left\{ e_j^{(W)} \right\}_j,$$

equation 9 may be formulated to the following equation (10) :

$$eq\ 10\ \ \ u^{(W)} = e_j^{(W)} u^j, \qquad K_{ij}^{(W)} u^j = F_i$$

Now the following equation (11) is defined:

$$\text{eq 11} \qquad K_{ij}^{(W)} \equiv e_i^{(W)} \cdot K e_j^{(W)}, \qquad F_i \equiv e_i^{(W)} \cdot F = e_i^{(W)} \cdot F_{(W)}$$

where $K_{ij}^{(W)}$ is referred to as a coarse grid matrix. The equal sign in the second equation is due to the orthogonality of **W** with the image space

$$K\left( W^c \oplus_K V^{(a)} \right))$$

of fine space $W^c \oplus_K V^{(a)}$ by **K**.

Now consider to solve, among k-orthogonally direct sum decomposed equations, equation (6) by the direct method, and equation (7) by the iteration method. When applying the iteration method to equation (7), iterative equation of n-th step may be written as following equations (12) and (13):

$$\text{eq 12} \qquad Ku_n^{(a)} + r_{(a)_n} = F_{(a)}, \qquad u_n^{(a)} \in V^{(a)}, \qquad F_{(a)} \in KV^{(a)}$$

$$\text{eq 13} \qquad r_{(a)_n} \equiv F_{(a)} - Ku_n^{(a)}, \qquad u_n \equiv u^{(Y)} + u_n^{(a)}$$

where $r_{(a)_n}$ designates to the residual error. Note that $r_{(a)_n} \in KV^{(a)}$. For the iteration method, the CG method with preprocess, which includes $P^{(a)}GP^{(a)T}$ (where G is symmetric) as the preprocess determinant: $P^{(a)}GP^{(a)T}$ -CG method, equations (14) to (16) will be adopted:

$$\text{eq. 14} \qquad p_0 = P^{(a)}Gr_{(a)_0} \in V^{(a)}$$

$$\text{eq 15} \qquad u_{n+1}^{(a)} = u_n^{(a)} + \alpha_n p_n, \qquad r_{(a)_{n+1}} = r_{(a)_n} - \alpha_n K p_n, \qquad \alpha_n \equiv \frac{r_{(a)_n} \cdot Gr_{(a)_n}}{p_n \cdot K p_n}$$

$$\text{eq 16} \qquad p_{n+1} = P^{(a)}Gr_{(a)_{n+1}} + \beta_n p_n, \qquad \beta_n \equiv \frac{r_{(a)_{n+1}} \cdot Gr_{(a)_{n+1}}}{r_{(a)_n} \cdot Gr_{(a)_n}}$$

where $p_n$ designates a search direction vector of $P^{(a)}GP^{(a)T}$ - CG method. Note that $P^{(a)T} r_{(a)_n} = r_{(a)_n} \in KV^{(a)}$ . As shown here, the method which solves one of equations k-orthogonally direct sum decomposed by the CG method with preprocess is referred to as conjugate projected gradient (CPG) method. In the discussion which follows, such method will be referred to as projected CG method, including solving the other of equations by direct method, for the sake of convenience.

K-orthogonal projector to the subspace $W \oplus_K V^{(a)}$ is designated to $P^{(W+a)}$. Although it is impossible to directly compute $P^{(a)}$ itself, $P^{(W+a)}$ may be computable, and now consider a case that the base of **W**,

$$\left\{ e_j^{(W)} \right\}_j$$

is given. In such a case the preprocess computation of $P^{(a)}Gr_{(a)_n}$ in equations (14) and (16) may be conducted as follows: $P^{(a)}Gr_{(a)_n}$ may be rewritten as equation (17) :

$$\text{eq 17} \qquad P^{(a)}Gr_{(a)_n} = P^{(W+a)}Gr_{(a)_n} - \mu_n^{(W)}, \qquad K\mu_n^{(W)} = P^{(W)T}KGr_{(a)_n}$$

$\mu_n^{(w)} \in W$ can be determined from equation (4). The preprocessing computation $P^{(a)}Gr_{(a)_n}$ can be reduced to the coarse grid problem of equation (18).

$$\text{eq 18} \qquad \mu_n^{(W)} \in W : K\mu_n^{(W)} = {P^{(W)}}^{\mathrm{T}} KGr_{(a)_n}$$

The coarse, grid problem can be solved by following the procedure of equation (10).

To characterizing the CGCG method, conventional finite element method parallel solver algorithm, DDM, BDD method, parallel CG method are now described herein below. As will be described, existent finite element method parallel solver algorithm, DDM, BDD method based on the domain decomposition may be considered to pertain a projected CG method based on the k-orthogonal direct sum decomposition method. In the following, V is defined as space of all degree of freedom in the structure problem determined according to the finite element method, and the linear equation to be solved is given as equation (19) by:

$$\text{eq 19} \qquad Ku = F, \qquad u, F \in V$$

where **K** designates to a stiffness matrix.

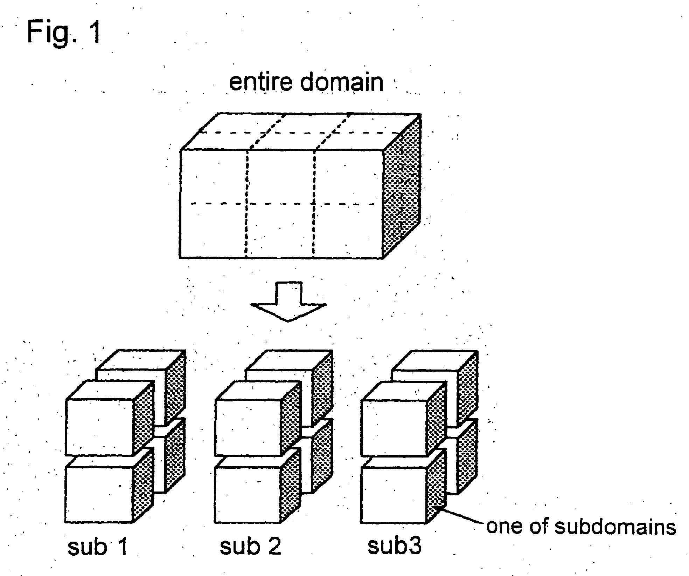

There is a domain decomposition method (DDM) conceived as a method for efficiently solving (in particular in the parallel processing) a very large scale problem (a problem having the degree of freedom of or more than approximately 1,000,000). Elements decomposed according to the finite element method and adjoining each other are appropriately grouped. The spatial domain occupied by a group is referred to as a subdomain (see Fig. 1). The space is hierarchically decomposed and 'scattered such that the entire domain is at first decomposed to subdomains, then a subdomain is decomposed to finite elements, and so on. The process on the entire domain will be split into two levels, a process for intra-subdomain and a process for inter-subdomain. The process for intra-subdomain may be paralleled. The two step process as described above may be achieved by separately processing the displacement into the displacement within a subdomain in response to a stress applied to the inside of subdomain, and the remaining displacement in response to a stress applied to the boundary between subdomains (internal boundary). The latter displacement may be further separated into the displacement within the subdomain and the displacement on the internal boundary, the former one is the slave variable of the latter. The degree of freedom of the internal boundary, which is an independent variable, may be solved by the CG method. By solving the internal boundary, the displacement within a subdomain can be determined as the displacement of non-load with the boundary condition of the displacement on the boundary.

More specifically, the entire domain $\overline{\Omega}$ occupied by the structure is decomposed to the boundary $\Gamma$, domain fused of entire contents of subdomains $\Omega_i$, and internal boundary $\Gamma_s$. $\Gamma$ and $\Gamma_s$ may be partly overlapped. The freedom space of the admissible displacement on the $\overline{\Omega}$ constitutes the total space of the degree of freedom **V.** By using a form function array $\{\varphi_\alpha\}_\alpha$ as the standard orthogonal base, an inner product is defined to **V.** The inner product may depend on the $\{\varphi_\alpha\}_\alpha$, and may be set for the convenience of computation which may vary according to the digitizing method, thus may have neither objective nor physical meaning. The domain $\overline{\Omega}$-$\Gamma_s$ include $\Omega_i$. The space **V**$^i$ of the degree of freedom of the admissible displacement on the $\overline{\Omega}$-$\Gamma_s$' is perpendicular to the space Vs of the degree of freedom of the admissible displacement on the internal boundary $\Gamma_s$, The entire space of the degree of freedom **V** may be orthogonally direct sum decomposed to **V**$^i$ and **V**$^s$ as given by equation (20) :

$$\text{eq 20} \qquad V = V_i \oplus V_s, \qquad V_i \perp V_s$$

Based on this direct sum decomposition, linear transform of positive fixed set point may be block decomposed to

$$K = \begin{pmatrix} K_{ii} & K_{is} \\ K_{si} & K_{ss} \end{pmatrix},$$

and diagonalized as given by equation (21) :

$$\text{eq 21} \qquad K = \begin{pmatrix} K_{ii} & K_{is} \\ K_{si} & K_{ss} \end{pmatrix} = \begin{pmatrix} 1 & \\ K_{si}K_{ii}^{-1} & 1 \end{pmatrix}\begin{pmatrix} K_{ii} & \\ & S \end{pmatrix}\begin{pmatrix} 1 & K_{ii}^{-1}K_{is} \\ & 1 \end{pmatrix}$$

where **S** is Schur's element. Projectors $\mathbf{P}^{(i)}$, $\mathbf{P}^{(s)}$ may be defined as equation (22):

$$\text{eq 22} \qquad P^{(i)} \equiv \begin{pmatrix} 1 & K_{ii}^{-1}K_{is} \\ & 0 \end{pmatrix}, \qquad P^{(s)} \equiv 1 - P^{(i)} = \begin{pmatrix} 0 & -K_{ii}^{-1}K_{is} \\ & 1 \end{pmatrix}$$

where $\mathbf{P}^{(s)}$ causes the displacement on the internal boundary $\Gamma_s$ to correspond to the displacement $\overline{\Omega}\text{-}\Gamma_s$ that has this boundary condition and receives no stress. From the definition equations (23) and (24) can be derived:

$$\text{eq 23} \qquad KP^{(i)} = \begin{pmatrix} 1 & \\ K_{si}K_{ii}^{-1} & 1 \end{pmatrix}\begin{pmatrix} K_{ii} & \\ & 0 \end{pmatrix}\begin{pmatrix} 1 & K_{ii}^{-1}K_{is} \\ & 1 \end{pmatrix} = \begin{pmatrix} K_{ii} & K_{is} \\ K_{si} & K_{si}K_{ii}^{-1}K_{is} \end{pmatrix}$$

$$\text{eq 24} \qquad KP^{(s)} = \begin{pmatrix} 0 & \\ & S \end{pmatrix}$$

therefore can be written as equation (25):

$$\text{eq 25} \qquad K\begin{pmatrix} P^{(i)} \\ P^{(s)} \end{pmatrix} = \begin{pmatrix} P^{(i)T} \\ P^{(s)T} \end{pmatrix}K$$

where $\mathbf{P}^{(i)}$ and $\mathbf{P}^{(s)}$ are k-orthogonal projectors, which satisfy the condition $\mathbf{P}^{(i)} + \mathbf{P}^{(s)} = 1$. Note that

$$\begin{pmatrix} 0 & \\ & S \end{pmatrix} = P^{(s)T}KP^{(s)}.$$

Therefore, from these projectors, **V** may be k-orthogonal direct sum decomposed to equation (26) :

$$\text{eq 26} \qquad V = V^{(i)} \oplus V^{(s)}, \qquad V^{(i)} \perp_K V^{(s)}, \qquad V^{(i)} \equiv P^{(i)}V, \qquad V^{(s)} \equiv P^{(s)}V$$

The relationship between

$$\begin{pmatrix} V^i & V^s \end{pmatrix}$$

and

$$\left( \begin{array}{cc} \mathbf{V}^{(i)} & \mathbf{V}^{(s)} \end{array} \right)$$

may be written as equation (27):

$$\text{eq } 27 \qquad \mathbf{V}^{(i)} = \mathbf{V}^i, \qquad \mathbf{KV}^{(s)} = \begin{pmatrix} 0 \\ \mathbf{SV}^s \end{pmatrix}, \qquad \mathbf{V}^{(s)} = \mathbf{P}^{(s)}\mathbf{V}^s = \begin{pmatrix} -\mathbf{K}_{ii}^{-1}\mathbf{K}_{is} \\ 1 \end{pmatrix}\mathbf{V}^s$$

Following can be derived therefrom for $\mathbf{V}^{(s)}$ : the second equation indicates that $\mathbf{V}^{(s)}$ is a space of displacement where the reaction on $\overline{\Omega}$-$\Gamma_s$ is zero. On the other hand the third equation indicates that $\mathbf{V}^{(s)}$ is a space of displacement on $\overline{\Omega}$, which has as geometric boundary condition the displacement on the $\Gamma_s$. Therefore these two characteristics of $\mathbf{V}^{(s)}$ are equal. Since the eigenspace belonging to the eigenvalue 0 of the projector $\mathbf{P}^{(s)}$, i.e., $\mathbf{kerP}^{(s)}$, may be $\mathbf{kerP}^{(s)} = \mathbf{V}^{(i)} = \mathbf{V}^i$, then $\mathbf{V}^s$ and $\mathbf{V}^{(s)}$ are linearly uniform. Thus the limitation of $\mathbf{P}^{(s)}$ to $\mathbf{V}^s$, $\mathbf{V}^s \rightarrow \mathbf{V}^{(s)}$, can be found to be linearly uniform. This indicates that when $\mathbf{V}^{(s)}$ is a variable space, $\mathbf{V}^s$ can be instead used for the variable space.

The direct method space Y and iterative method space $\mathbf{V}^{(a)}$ of k-orthogonal direct sum decomposed space and equation may be defined as following equation (28):

$$\text{eq } 28 \qquad Y = V^{(i)}, \qquad V^{(a)} = V^{(s)}$$

and the projection CG method (J. Mandel, M. Brezina: Balancing Domain Decomposition: Theory and Performance in two and Three Dimensions, MGNet, http://casper.cs.yale.edu/mgnet/www/mgnet-papers.ht ml) is applied to'the preprocessing determinant G of equation (14) to (16) with unit determinant G =1 to yield the Domain Decomposition Method (DDM). $\mathbf{V}^{(i)}$ indicates a space of the degree of freedom on the admissible displacement of $\overline{\Omega}$-$\Gamma_s$, $\mathbf{V}^s$ indicates a space of the degree of freedom of the displacement that does not receive any stress on the $\overline{\Omega}$, with the admissible displacement on the $\Gamma_s$ and the boundary condition thereof (more exactly, displacement restriction condition). $\mathbf{KV}^{(s)}$ is a space of the degree of freedom of the reaction force on the internal boundary corresponding to the displacement of $\mathbf{V}^{(s)}$. In the conventional DDM algorithm $\mathbf{V}^s$ is used for the variable space instead of $\mathbf{V}^{(s)}$, according to the foregoing.

By setting- G other than the unit determinant, the DDM with preprocessing can be achieved. For the usual preprocessing determinant G, preprocess is valid when

$$G \cong S^- \equiv \begin{pmatrix} 0 \\ & S^{-1} \end{pmatrix} = P^{(s)}K^{-1}P^{(s)^T} \; .$$

Preprocess used in the CG method of the DDM, includes Neumannpreprocess (P. Le. Tallec: Domain decomposition methods in computational mechanics, Computational Mechanics Advances 1 (2) (1994) 121-220). This preprocess uses Neumann preprocess determinant as the above preprocess determinant $\mathbf{G}$, instead of unit determinant of 1. Neumann preprocess determinant may be defined as equation (29) below, as representation of block decomposition corresponding to equation (24) by using general inverse determinant $\mathbf{S}^{l-}$ of Schur auxiliary element $\mathbf{S}^l$ (also referred to as local Schur auxiliary element) of the local stiffness matrix $\mathbf{K}^l$ in each subdomain I:

$$\text{eq } 29 \qquad G = \begin{pmatrix} 0 \\ & \displaystyle\sum_{I} N^I D^I S^{I-} D^{I^T} N^{I^T} \end{pmatrix}$$

where I is the index of subdomain by domain decomposition, $N^I$ is 0-1 component determinant, which maps the degree of freedom of subdomain I to the degree of freedom of the entire domain, $\{D^I\}_I$ is the set

$$1 = \sum_I N^I D^I N^{I^T}$$

of decomposition determinant of 1 to each subdomain. This preprocess is likely not to satisfy the condition $\mathbf{G} \cong \mathbf{S}^-$, depending on the selected general inverse determinant $\mathbf{S}^{I-}$.

By applying Neumann preprocess to the DDM, .undetermined rigid displacement for each subdomain may be interfused for each iteration, according to the arbitrary selection of $\mathbf{S}^{I-}$. This may cause random floating movement in subdomains, and may be the cause of aggravation of the efficiency of iterative convergence. This may also be the cause of unsatisfying the condition $\mathbf{G} \cong \mathbf{S}^-$. The BDD method (Balancing Domain Decomposition method, J. Mandel: Balancing Domain Decomposition, Communications on Numerical Methods in Engineering 9 (1993) 233-341., J. Mandel, M. Brezina: Balancing Domain Decomposition: Theory and Performance in Two and Three Dimensions, MGNet, http://casper. cs.yale.edu/mgnet/www/mgnet-papers.html, ARASOL An Integrated Programming Environment for Parallel Sparse Matrix Solvers (Project No. 20160), Deliverable D 2.4e Final report Domain Decomposition Algorithms for Large Scale Industrial Finite Element Problems, July 30, 1999) is a solution based on the DDM by using the CG method with preprocessing for the displacement on the internal boundary. Specifically for a static problem of micro deformation of linear material, this method divides the displacement responsive to the stress applied onto the internal boundary to the rigid displacement for each subdomain and residual distortional displacement to solve the former freedom by using the direct methodprior to the latter freedom, which will be solved by the CG method with preprocessing. In other words, projection that avoids the interference of the freedom of rigid displacement for each subdomain already solved in advance is added to Neumann preprocessing for every iteration. More specifically, this projection is introduced in such a manner that it eliminates any stress which may cause random floating movement in the subdomain, or it is a correspondence $\mathbf{F} \rightarrow \mathbf{F}_{(a)}$ in equations (7) and (8) of k-orthogonally direct sum decomposition, or the projection of.residual error $\mathbf{r} \rightarrow \mathbf{r}_{(a)}$ in the projected CG method algorithm. As can be seen from the foregoing, the projection as described above is referred to as balancing, which suppresses the floating movement in subdomains by improving the DDM with Neumann preprocessing.

More specifically, subspace $\mathbf{V}^{(s)} = \mathbf{P}^{(s)}\mathbf{V}^s$ in the DDM is further k-orthogonally direct sum decomposed as follows: by considering a movement that sum spaces across I of subspace including $\mathbf{kerS}^I$, for example every rigid displacement of a subdomain are summed for all of subdomains, the space of that degree of freedom is defined as a coarse space $\mathbf{W}$. $\mathbf{W}$ is a subspace of $\mathbf{V}^{(s)}$. $\mathbf{V}^{(s)}$ is then k-orthogonally direct sum decomposed to $\mathbf{W}$ and k-orthogonal auxiliary space $\mathbf{V}^{(t)}$ for $\mathbf{V}^{(s)}$. Now by defining a pair of k-orthogonal projectors $\mathbf{P}^{(W)}$ and $\mathbf{P}^{(t)}$, equation (30) can be given:

$$\text{eq } 30 \qquad \mathbf{P}^{(s)} = \mathbf{P}^{(W)} + \mathbf{P}^{(t)}, \qquad \mathbf{K}\begin{pmatrix} \mathbf{P}^{(W)} \\ \mathbf{P}^{(t)} \end{pmatrix} = \begin{pmatrix} \mathbf{P}^{(W)^T} \\ \mathbf{P}^{(t)^T} \end{pmatrix}\mathbf{K}$$

The space of all freedom $\mathbf{V}$ may be k-orthogonal direct sum decomposed to equations (31) and (32):

$$\text{eq } 31 \qquad V = V^{(i)} \oplus W \oplus V^{(t)}, \qquad V^{(i)} \perp_K W, \qquad V^{(i)} \perp_K V^{(a)}, \qquad W \perp_K V^{(t)}$$

$$\text{eq } 32 \qquad W = P^{(W)}V, \qquad V^{(t)} \equiv P^{(t)}V$$

Now define the direct method space and iterative method space of k-orthogonal direct sum decomposition of the space and equation as equation (33):

$$\text{eq } 33 \qquad Y = V^{(i)} \oplus_K W, \qquad V^{(a)} = V^{(t)}$$

In the BDD method, the projection CG method (J. Mandel, M. Brezina: Balancing Domain Decomposition:

Theory and Performance in Two and Three Dimensions, MGNet, http://casper.cs.yale.edu/mgnet/www/mgnet-papers. ht ml) is applied thereto after having preprocessing determinant **G** of equations (14) to (16) substituted for Neumann preprocessing determinant. Inparticular, preprocessing corresponding to equations (17) and (18) may be rewritten as equations (34) and (35) as follows, since $P^{(W+a)} = P^{(s)}$ :

$$\text{eq 34} \qquad P^{(a)}Gr_{(a)_n} = P^{(s)}Gr_{(a)_n} - \mu_n^{(W)}$$

$$\text{eq 35} \qquad \mu_n^{(W)} \in W : K\mu_n^{(W)} = P^{(W)^T}KGr_{(a)_n}$$

The projection $Gr_{(a)_n} \rightarrow P^{(s)}Gr_{(a)_n}$ may be computed as stated in equation (22).

The iterative space $V^{(t)}$ of the BDD method is also defined together with the later definition of W $^I$ of the local coarse space. This is also a balanced space. $K^{-1}$-orthogonal projection from a balanced space to an image space $SV^{(a)}$, $r_{(a)_n} \in SV^s \rightarrow P^{(a)^T}r_{(a)_n} \in SV^{(a)}$ is referred to as "balancing" (J. Mandel: Balancing Domain Decomposition, Communications on Numerical Methods in Engineering 9 (1993) 233-341., J. Mandel, M. Brezina: Balancing Domain Decomposition: Theory and Performance in Two and Three Dimensions, MGNet, http://casper.cs.yale.edu/mgnet/ www/mgnet-papers.ht ml). Balancing may not appear directly in algorithm equations (14) to (16) of the projection CG method applied to the BDD method, however is corresponded to k-orthogonal projection $Gr_{(a)_n} \in V^s \subset V \rightarrow P^{(a)}Gr_{(a)_n} \in V^{(a)}$ equations (14) and (16). In contrast to the DDM, even when **G** of BDD method may be $G \neq S^-$, if $P^{(a)}GP^{(a)^T} \cong P^{(a)}S^-P^{(a)^T} = P^{(a)}K^{-1}P^{(a)^T}$ then it is valid for the preprocessing. Neumann preprocessing determinant equation (29) satisfies this condition, which may solve the problem of the DDM with Neumann preprocessing, as stated above in the beginning of this section.

In the parallel CG method no domain decomposition is conducted, rather all freedom space **V** is processed in the CG method. In addition k-orthogonal direct sum decomposition of **V** is not performed. This corresponds Y = {0} for the direct method space. If the problem to be solved is large scaled, and the dimensions of vector space **V** is large, then the domain subject to be analyzed will be split into some spaces (referred to as "part"), the degree of freedom for every subspaces will be processed in different processors based on the **V** decomposition (decomposition that leaves boundary overlapped) along with the division. Interprocess communication is necessary only when some computations are conducted, which require information exchange between subspaces such as the inner product of vectors or matrix-vector product.

As can be seen, solutions according to the DDM (Domain Decomposition Method), the DDM with Neumann preprocessing, the BDD (Balancing Domain Decomposition) method, and the parallel CG method have been described, for solving a very large scale structure problem. However, there has been pointed out the problems associated therewith that none of these methods may determine the solution because of divergence at the time of solving a very large scaled structure problem, and the computation is very time-consuming. The present invention has been made in view of the above circumstances and has an object to overcome the above problems and to provide a systematic CGCG method for solving a very large scaled structure problem having the degree of freedom of a million or more, which allows determining the solution without divergence of solutions, with less number of steps of iterative computation, and with less time-consuming computation.

SUMMARY OF THE INVENTION

The present invention provides a system for solving a very large scaled structure problem, a program for operating the system, and a computer readable recording medium having the program stored thereon. The CGCG method is a finite element method solver algorithm for a very large scaled structure problem, which uses the projection CG method with preprocessing, by performing domain decomposition, defining thereby coarse space without regarding the inside of subdomain and boundary, and. adopting simple diagonal scaling for the preprocessing.

The present invention provides a parallel finite element method computing system for solving a very large scaled structure problem having the degree of freedom of one million (1,000,000) or more, characterized by a means for performing domain decomposition; a means for distributing a subdomain to a responsible part of each processor; a means for creating a rigid matrix; a means for defining overlapped movement of entire subdomain; a means for defining a default setting of projected CG method with preprocessing of all degree of freedom; a means for performing iterative computation of projected CG method with preprocessing of all degree of freedom; and a means for outputting a displacement solution.

Said means for defining overlapped movement of entire subdomain may further include a means for creating a projector for displaying all degree of freedom; a means for creating an overlapped movement matrix of entire subdomain; and a means for LU decomposing said overlapped movement matrix of entire subdomain.

Said means for defining a default setting of projected CG method with preprocessing of all degree of freedom may further include a means for setting initial displacement of all degree of freedom; a means for performing computation of initial residual error of all degree of freedom; a means for performing computation of diagonal scaling preprocessing; a means for performing computation of coarse grid preprocessing of all degree of freedom; and a means for defining an initial vector value in the search direction of CG method with all degree of freedom.

Said means for performing iterative computation of projected CG method with preprocessing of all degree of freedom may further include a means for updating the displacement of all degree of freedom; a means for updating the residual error of all degree of freedom; a means for performing computation of diagonal scaling preprocessing; a means for performing computation of coarse grid preprocessing of all degree of freedom; a means for updating vectors in the search direction of CG method of all degree of freedom; and a means of determining the convergence.

The present invention may also provide a program for operating said system. More specifically, the present invention provides a parallel finite element method computing program used in a parallel finite element method computing system for solving a very large scal'ed structure problem having the degree of freedom of one million (1,000,000) or more, characterized by operating as a means for performing domain decomposition; a means for distributing a subdomain to a responsible part of each processor; a means for creating a rigidmatrix; ameans for defining overlapped movement of entire subdomain; a means for defining a default setting of projected CG method with preprocessing of all degree of freedom; a means for performing iterative computation of proj ected CG method with preprocessing of all degree of freedom; and a means for outputting a displacement solution,

in which said means for defining overlapped movement of entire subdomain may further operate as a means for creating a projector for displaying all degree of freedom; a means for creating an overlapped movement matrix of entire subdomain; and a means for LU decomposing said overlapped movement matrix of entire subdomain;

in which said means for defining a default setting of projected CG method with preprocessing of all degree of freedom may further operate as a means for setting initial displacement of all degree of freedom; a means for performing computation of initial residual error of all degree of freedom; a means for performing computation of diagonal scaling preprocessing; a means for performing computation of coarse grid preprocess ing of all degree of freedom; and a means for defining an initial vector value in the search direction of CG method with all degree of freedom;

inwhich said means forperforming iterative computation of projected CG method with preprocessing of all degree of freedom may further operate as a means for updating the displacement of all degree of freedom; a means for updating the residual error of all degree of freedom; a means for performing computation of diagonal scaling preprocessing; a means for performing computation of coarse grid preprocessing of all degree of freedom; a means for updating vectors in the search direction of CG method of all degree of freedom; and a means of determining the convergence.

The present invention provides a computer readable recording medium having the program stored thereon for operating said system. More specifically, the present invention provides a computer readable recording medium having stored thereon a parallel finite element method computing program used in a parallel finite element method computing system for solving a very large scaled structure problem having the degree of freedom of one million (1,000,000) or more, characterizedbyoperating as a means for performing domain decomposition; a means for distributing a subdomain to a responsible part of each processor; a means for creating a rigid matrix; a means for defining overlapped movement of entire subdomain; a means for defining a default setting of projected CG method with preprocessing of all degree of freedom; a means for performing iterative computation of projected CG method with preprocessing of all degree of freedom; and a means for outputting a displacement solution,

in which said means for defining overlapped movement of entire subdomain may further operate as a means for creating a projector for displaying all degree of freedom; a means for creating an overlapped movement matrix of entire subdomain; and a means for LU decomposing said overlapped movement matrix of entire subdomain;

in which said means for defining a default setting of projected CG method with preprocessing of all degree of freedom may further operate as a means for setting initial displacement of all degree of freedom; a means for performing computation of initial residual error of all degree of freedom; a means for performing computation of diagonal scaling preprocessing; a means for performing computation of coarse grid preprocessing of all degree of freedom; and a means for defining an initial vector value in the search direction of CG method with all degree of freedom;

in which saidmeans for performing iterative computation of projected CG method with preprocessing of all degree of freedom may further operate as a means for updating the displacement of all degree of freedom; a means for updating the residual error of all degree of freedom; a means for performing computation of diagonal scaling preprocessing; a means for performing computation of coarse grid preprocessing of all degree of freedom; a means for updating vectors in the search direction of CG method of all degree of freedom; and a means of determining the convergence.

The above and further objects and novel features of the present invention will more fully appear from following detailed description of a preferred embodiment, when the same is read in connection with the accompanying drawings. It is to be expressly understood, however, tha the drawings are for the purpose of illustration only and not intended as a definition of the limits of the present invention.

BRIEF DESCRIPTION OF THE DRAWINGS

The accompanying drawings, which are incorporated in and constitute a part of this specification illustrate an embodiment of the invention and, together with the description, serve to explain the objects, advantages and principles of the invention. In the drawings,

Fig. 1 is a schematic diagram illustrating domain decomposition; and
Fig. 2 is a schematic flowchart illustrating computation in the CGCG method.

DETAILED DESCRIPTION

The CGCG method is a finite element method solver algorithm used for a very large scaled structure problem, using a projected CG method with preprocessing, by performing domain decomposition, defining a coarse space without distinguishing inside of subdomain with boundary, and adopting simple diagonal scaling for the preprocess. Similar to the DDM and. the BDD method, the CGCG method is formed on the projected CG method, which is based on the domain decomposition. First, define Y=**W**, and according to equation (3), all freedom space **V** is k-orthogonally direct sum decomposed as following equation (36):

$$\text{eq } 36 \qquad \mathbf{V} = \mathbf{W} \oplus \mathbf{V}^{(a)}, \qquad \mathbf{W} \perp_K \mathbf{V}^{(a)}, \qquad \begin{pmatrix} \mathbf{W} \\ \mathbf{V}^{(a)} \end{pmatrix} = \begin{pmatrix} \mathbf{P}^{(W)} \\ \mathbf{P}^{(a)} \end{pmatrix} \mathbf{V}$$

here lies a problem to select which subspace of V as the coarse space **W.** In the CGCG method, a subspace of **V** is to be elected which represents for **W** some limited movement (such as rigid motion) for each subdomain in the domain decomposition.

For example, in a manner similar to the BDD method, if a space having the degree of freedom of movement overlapping for every subdomains rigid displacement of each of subdomains is selected for **W** , then **V**$^{(a)}$ constitutes the space of displacement indicative of distortion motion within the subdomain. Thus in comparison with equation (33) of the BDD method the direct method space and repetitive method space may be formed as shown in equation (37) :

$$\text{eq } 37 \qquad Y = W, \qquad V^{(a)} = V^{(i)} \oplus V^{(t)}, \qquad V^{(i)} \perp_K V^{(t)}$$

In this case, while the BDD method solves by direct method the degree of freedom of **V**$^{(i)}$, the CGCG method attempts to solve it by using the CG method. In this situation the CGCG method imposes much more burden on .the CG method and less on direct method. Also in the projected CG method preprocessing of the CGCG method, the direct method has less roles due to the lack of projection processing $\mathbf{Gr}_{(a)n} \to \mathbf{P}^{(s)}\mathbf{Gr}_{(a)n}$ of equation (34) of the BDD method.

The management of the implementation of coarse space W may also differ, reflecting the difference between the DDM method and the parallel CG method. In the DDM, as **V**$^s$ is used for the variable space, the displacement of entire domain is divided into the displacement inside the subdomain and that on the internal boundary. In the parallel CG method subdomain is not divided into its inside and internal boundary but the inside and internal boundary of subdomains are handled as whole. Coarse space **W** in the BDD method may be defined as follows: The rigid displacement in the boundary of each subdomain (part of internal boundary) is at first formulated, then the space **W**$^s$ overlapping over the entire subdomain is set. Then the result will be k-orthogonally projected by **P**$^{(s)}$ of equation (22) to expand to rigid displacement in the subdomain to yield **W** (i.e., **W** = **P**$^{(s)}$**W**$^s$). On the other handcoarsespace **W** in the CGCG method is set by directly formulating the rigid displacement of both inside and boundary entirely for each subdomain to overlap across that subdomain. Accordingly the preprocessing of the projected CG method involves much effort in solving the degree of freedom of space **W**$^s$ as well as in direct method processing for each and every subdomain (due to the computation of Schur auxiliary element). In contrast to the BDD method, the CGCG method may need only to solve the degree of freedom of rigid displacement for each subdomain including its inside.

Now equation (1) is decomposed to equations (38), (39), (40) in a manner similar to equations (6) to (8) :

$$\text{eq } 38 \qquad Ku^{(W)} = F_{(W)}, \qquad u^{(W)} \in W, \qquad F_{(W)} \in KW$$

$$\text{eq 39} \qquad Ku^{(a)} = F_{(a)}, \qquad u^{(a)} \in V^{(a)}, \qquad F_{(a)} \in KV^{(a)}$$

$$\text{eq 40} \qquad u = u^{(a)} + u^{(W)}, \qquad F = F_{(a)} + F_{(W)}$$

Equation (38) represents the coarse grid problem for determining **W** component of displacement $u^{(W)}$, equation (39) represents the equation for determining $V^{(a)}$ component of displacement $u^{(a)}$. The CG method solves equation (38) using modified Choleski method, which is one of direct methods, and equation (39) using the CG iterative processing with preprocessing of the projected CG method, in a manner similar to the projected CG method. The preprocessing determinant $\bar{\mathbf{G}}$ of the CG iterative method with preprocessing is selected, in accordance with equations (14) to (16), to be $\mathbf{G}=\mathbf{D}_K^{-1}$ to define equation (41):

$$\text{eq 41} \qquad \bar{G} = P^{(a)}D_K^{-1}P^{(a)^T}$$

where $\mathbf{D}_K^{-1}$ designates to an inverse matrix of $\mathbf{D}_K$, $\mathbf{D}_K$ to a diagonal matrix of K (a diagonal matrix having diagonal components equal to those of K). The effect on residual error $\mathbf{r}_{(a)_n} \in \mathbf{KV}^{(a)}$ may be substantially $\bar{\mathbf{G}}\mathbf{r}_{(a)_n} = \mathbf{P}^{(a)}\mathbf{D}_K^{-1}\mathbf{r}_{(a)_n}$, i.e., the preprocessing in the CGCG method is the combination of diagonal scaling of **K** with k-orthogonal projection $\mathbf{P}^{(a)}$ to the iterative space $\mathbf{V}^{(a)}$.

In the BDD method Neumann preprocessing is performed, which is a heavy processing for computing general inverse matrix $\mathbf{S}^{I-}$ of local Schur auxiliary element $\mathbf{S}^I$ for every subdomain, while on the other hand the CGCG method reduces the burden by using much simpler and lightweight preprocessing, namely diagonal scaling, to significantly decrease the computational cost and required amount of memory.

The definition of coarse space **W** in k-orthogonal decomposition equation (36) by the CGCG method will be now described below. I designates to the index of subdomains by the domain decomposition. The vector space made by the degree of freedom within the subdomain I is represented by $\mathbf{V}^I$. The subspace $\mathbf{W}^I$ of $\mathbf{V}^I$ is then defined, which is referred to as "local coarse space". Weighted overlap of

$$\left\{ W^I \right\}_I$$

of coarse space **W** defines as equation (42):

$$\text{eq 42} \qquad W \equiv \text{span}\left\{ N^ID^IW^I \right\}_I = \bigoplus_I N^ID^IW^I$$

where $\{D^I\}_I$ indicates the decomposition of I to subdomains in a manner similar to Neumann preprocessing,

$$1 = \sum_I N^ID^IN^{I^T} .$$

$\mathbf{W}^I$ is the space of displacement indicative of defined movement (for example rigid motion) of subdomain I. $\mathbf{m}^I \equiv \mathbf{dimW}^I$ is defined as the dimension of $\mathbf{W}^I$, $\{Z_j^I\}_{j=1,L,m^I}$ and as the base of $\mathbf{W}^I$.

$$\text{eq 43} \qquad \left\{ N^ID^IZ_j^I \right\}_{j=1,L,m^I_I}$$

Equation (43) constitutes the base of **W,** and the dimension of **W** is

$$\sum_I \dot{m}^I \cdot$$

If $\mathbf{W}^I$ satisfies the condition $\mathbf{kerS}^I \subset \mathbf{W}^I$ in particular, the subspace of corresponding fine space is referred to as balanced space. In the BDD method, which performs Neumann preprocessing, $\mathbf{W}^I$ needs to satisfy the condition $\mathbf{kerS}^I \subset \mathbf{W}^I$, while the CGCG may not. In other words, The iterative space $\mathbf{V}^{(a)}$ of the CGCG method does not need to be a balanced space.

Now consider a rigid motion, as a defined movement in the subdomain I. At this time $\mathbf{W}^I$ may be practically formed as follows. The rigid motion in the subdomain I can be represented as described below. By defining $\mathbf{X}^I_\alpha$ as the initial coordinate of node $\alpha$ on the subdomain I, $\mathbf{x}^I_\alpha$ as the coordinate after the deformation, following equations (44), (45), (46) can be given:

$$\text{eq 44} \qquad x^I_\alpha = P_j v^j + e^{O_j \theta^j} X^I_\alpha$$

$$\text{eq 45} \qquad P_1 \equiv \begin{pmatrix} 1 \\ 0 \\ 0 \end{pmatrix}, \qquad P_2 \equiv \begin{pmatrix} 0 \\ 1 \\ 0 \end{pmatrix}, \qquad P_3 \equiv \begin{pmatrix} 0 \\ 0 \\ 1 \end{pmatrix}$$

$$\text{eq 46} \qquad O_1 \equiv \begin{pmatrix} 0 & & \\ & & -1 \\ & 1 & \end{pmatrix}, \quad O_2 \equiv \begin{pmatrix} & & 1 \\ & 0 & \\ -1 & & \end{pmatrix}, \quad O_3 \equiv \begin{pmatrix} & -1 & \\ 1 & & \\ & & 0 \end{pmatrix}$$

When considering micro-deformation, following equations (47) and (48) can be derived:

$$\text{eq 47} \qquad x^I_\alpha \cong P_j v^j + (1 + O_j \theta^j) X^I_\alpha$$

$$\text{eq 48} \qquad u^I_\alpha \cong P_j v^j + O_j X^I_\alpha \theta^j = v + \theta \times X^I_\alpha, \qquad v \equiv \begin{pmatrix} v^1 \\ v^2 \\ v^3 \end{pmatrix}, \qquad \theta \equiv \begin{pmatrix} \theta^1 \\ \theta^2 \\ \theta^3 \end{pmatrix}$$

Now define $\mathbf{W}^I$ by 6 dimension vector space having the base of six displacement $\{Z^I_j\}_{j=1,L,6}$ on the subdomain I defined by the following condition. This means following equations (49) and (50):

$$\text{eq 49} \qquad \begin{matrix} Z^I_j & : & Z^I_j(X^I_\alpha) = P_j \\ Z^I_{3+j} & : & Z^I_{3+j}(X^I_\alpha) = O_j X^I_\alpha \end{matrix}, \qquad j = 1, 2, 3$$

$$eq\ 50 \qquad W^I \equiv \left\{\ \sum_{j=1}^{m^I} Z_j^I \mu^j\ \middle|\ \mu^j \in \mathbf{R}\ \right\}, \qquad m^I \leq 6$$

Note that in equation 50 following condition is taken into account. Depending on subdomains, the degree of freedom of rigid motion may be less than or equal to 5. In such a situation the number j of term $\mathbf{Z}_j^I$ should be renumbered such that the base becomes $\{\mathbf{Z}_j^I\}_{j=1,L\,,m^I}$, $\mathbf{m}^I \equiv \mathbf{dim}\ \mathbf{W}^I \leq 6$. Renumbering of the number j uses Gram-Schmidt orthogonal method.

The BDD method is different from the CGCG method in that it defines six displacements on the internal boundary for the $\{\mathbf{Z}_j^I\}_{j=1,L\,,6}$ defined by equation (49), instead of those on subdomain I.

It may be easy to apply the formulae of rigid motion as defined movement as above to the rigid motion of the solid model of the micro deformation problem. In case of the solid model, those six displacements $\{\mathbf{Z}_j^I\}_{j=1,L\,,6}$ on the subdomain I defined by equation (49) will have its node component $\alpha$ as equation (51) below:

$$\left\{ Z_1^I(X_\alpha^I),\ Z_2^I(X_\alpha^I),\ Z_3^I(X_\alpha^I),\ Z_4^I(X_\alpha^I),\ Z_5^I(X_\alpha^I),\ Z_6^I(X_\alpha^I) \right\}$$

$$eq\ 51 \qquad = \begin{pmatrix} 1 & 0 & 0 & 0 & X^{\alpha 3} & -X^{\alpha 2} \\ 0 & 1 & 0 & -X^{\alpha 3} & 0 & X^{\alpha 1} \\ 0 & 0 & 1 & X^{\alpha 2} & -X^{\alpha 1} & 0 \end{pmatrix}$$

where $\mathbf{X}_\alpha^I$ is the initial coordinate of the node $\alpha$ on the subdomain I.

Next, the application to the micro deformation problem shell model will be described. Now one of standard orthogonal bases at the contact space of the shell neutral plane at the node $\alpha$ is selected to be

$$\left( e_1^\alpha \quad e_2^\alpha \right), \qquad e_3^\alpha$$

is defined as the initial director of the node $\alpha$. A coordinate $\mathbf{x} = \mathbf{x}(\xi^1, \xi^2, \xi^3)$ of the point on a shell element can be written as equation (52):

$$eq\ 52 \qquad \mathbf{x} = \sum_\alpha N_\alpha(\xi^1, \xi^2)\left( X^\alpha + U^\alpha + \frac{a^\alpha \xi^3}{2}\left(1 + \varphi^\alpha \times\right) e_3^\alpha \right)$$

where $(\xi^1, \xi^2, \xi^3)$ is the local coordinate of that shell element. Also, $N_\alpha$, $X^\alpha$, $U^\alpha$, $\varphi^\alpha$ are shape functions of node $\alpha$, defined on the shell neutral plane, initial node coordinate, current node displacement, amount of rotation of the current director, respectively.

$$\sum_\alpha$$

indicates the sum over nodes included in the shell element in question.

The micro-translation of shell $\mathbf{x} \rightarrow \mathbf{x} + \mathbf{a}$ may be rewritten as equation (53):

$$\text{eq 53} \qquad \mathbf{x} \longrightarrow \mathbf{x}+\mathbf{a} = \sum_{\alpha} N_{\alpha}\left[ \mathbf{X}^{\alpha}+\mathbf{U}^{\alpha}+\mathbf{a}+\frac{a^{\alpha}\xi^{3}}{2}\left(1+\varphi^{\alpha}\times\right)\mathbf{e}_{3}^{\alpha}\right]$$

in other words, when focusing on the change of the node displacement $\mathbf{U}^{\alpha}$ and the amount or rotation of the current director $\varphi^{\alpha}$, following equation (54) can be yielded:

$$\text{eq 54} \qquad \begin{pmatrix} \mathbf{U}^{\alpha} \\ \varphi^{\alpha} \end{pmatrix} \longrightarrow \begin{pmatrix} \mathbf{U}^{\alpha}+\mathbf{a} \\ \varphi^{\alpha} \end{pmatrix}$$

Now consider the rigid micro-rotation of the shell. The displacement $\mathbf{U}^{\alpha}$ and the rotation of current director $\varphi^{\alpha}$ may be assumed microscopic. Now a rigid micro-rotation $1+O_{i}\theta^{i} =1+\theta\times$ is effectuated to the coordinate $\mathbf{x} = \mathbf{x}(\xi^1, \xi^2, \xi^3)$ . Now $\{O_{i}\}_{i=1,2,3}$ is the matrix defined by equation 46, and $\theta=(\theta^1\ \theta^2\ \theta^3)^{\mathsf{T}}$ is the vector in the rotating direction. The current node coordinate $\mathbf{X}^{\alpha}+\mathbf{U}^{\alpha}$ by the rigid micro-rotation, the amount of change of the current director

$$\psi^{\alpha} \cong \left(1+\varphi^{\alpha}\times\right)\mathbf{e}_{3}^{\alpha}$$

may be expressed as equation (55) when considering to microscopic amount first order:

$$\text{eq 55} \qquad \theta\times\left(\mathbf{X}^{\alpha}+\mathbf{U}^{\alpha}\right) \cong \theta\times\mathbf{X}^{\alpha}, \qquad \theta\times\left(1+\varphi^{\alpha}\times\right)\mathbf{e}_{3}^{\alpha} \cong \theta\times\mathbf{e}_{3}^{\alpha} = \theta^{\alpha}\times\mathbf{e}_{3}^{\alpha}$$

Now $\theta^{\alpha}$ can be written as a vector equation (56) , which projects $\theta$ to the contact space of the shell neutral plane at the node $\alpha$ ( subspace extending over

$$\left(\mathbf{e}_{1}^{\alpha}\quad\mathbf{e}_{2}^{\alpha}\right)) :$$

$$\text{eq 56} \qquad \theta^{\alpha} \equiv \left(\mathbf{e}_{1}^{\alpha}\quad\mathbf{e}_{2}^{\alpha}\right)\begin{pmatrix} \mathbf{e}_{1}^{\alpha}\cdot\theta \\ \mathbf{e}_{2}^{\alpha}\cdot\theta \end{pmatrix}$$

Thus the amount of change of entire coordinate $\mathbf{x}$ due to the rigid micro-rotation can be written by equation (57) :

$$\text{eq 57} \qquad \theta\times\mathbf{x} \cong \sum_{\alpha} N_{\alpha}\left(\theta\times\mathbf{X}^{\alpha}+\frac{a^{\alpha}\xi^{3}}{2}\theta^{\alpha}\times\mathbf{e}_{3}^{\alpha}\right)$$

Therefore the rigid micro-rotation of the shell can be rewritten as equation 58 as follows, when focusing on the node displacement $\mathbf{U}^{\alpha}$ and the amount of rotation of the current director $\varphi^{\alpha}$ :

$$\text{eq } 58 \qquad \begin{pmatrix} \mathbf{U}^\alpha \\ \boldsymbol{\varphi}^\alpha \end{pmatrix} \longrightarrow \begin{pmatrix} \mathbf{U}^\alpha + \boldsymbol{\theta} \times \mathbf{X}^\alpha \\ \boldsymbol{\varphi}^\alpha + \boldsymbol{\theta}^\alpha \end{pmatrix}$$

When combining the micro-translation $\mathbf{x} \rightarrow \mathbf{x} + \mathbf{a}$ and rigid micro-rotation

$$\mathbf{x} \rightarrow (1 + \boldsymbol{\theta} \times) \mathbf{x} \quad,$$

next equation can be yielded:

$$\text{eq } 59 \qquad \begin{pmatrix} \mathbf{U}^\alpha \\ \boldsymbol{\varphi}^\alpha \end{pmatrix} \longrightarrow \begin{pmatrix} \mathbf{U}^\alpha + \mathbf{a} + \boldsymbol{\theta} \times \mathbf{X}^\alpha \\ \boldsymbol{\varphi}^\alpha + \boldsymbol{\theta}^\alpha \end{pmatrix}$$

If the additional term

$$\begin{pmatrix} \mathbf{a} + \boldsymbol{\theta} \times \mathbf{X}^\alpha \\ \boldsymbol{\theta}^\alpha \end{pmatrix}$$

is written as component, equation (60) can be written:

$$\text{eq } 60 \qquad \begin{pmatrix} \mathbf{a} + \boldsymbol{\theta} \times \mathbf{X}^\alpha \\ \boldsymbol{\theta}^\alpha \end{pmatrix} = \begin{pmatrix} 1 & 0 & 0 & 0 & X^{\alpha 3} & -X^{\alpha 2} \\ 0 & 1 & 0 & -X^{\alpha 3} & 0 & X^{\alpha 1} \\ 0 & 0 & 1 & X^{\alpha 2} & -X^{\alpha 1} & 0 \\ 0 & 0 & 0 & e_1^{\alpha 1} & e_1^{\alpha 2} & e_1^{\alpha 3} \\ 0 & 0 & 0 & e_2^{\alpha 1} & e_2^{\alpha 2} & e_2^{\alpha 3} \end{pmatrix} \begin{pmatrix} a^1 \\ a^2 \\ a^3 \\ \theta^1 \\ \theta^2 \\ \theta^3 \end{pmatrix}$$

It indicates that the component of the node $\alpha$ in the six displacement $\{Z_j^I\}_{j=1,L,6}$ on the subdomain I defined by equation (49) may be expressed as following equation (61) :

$$\left\{ Z_1^I(X_\alpha^I),\ Z_2^I(X_\alpha^I),\ Z_3^I(X_\alpha^I),\ Z_4^I(X_\alpha^I),\ Z_5^I(X_\alpha^I),\ Z_6^I(X_\alpha^I) \right\}$$

eq 61

$$= \begin{pmatrix} 1 & 0 & 0 & 0 & X^{\alpha 3} & -X^{\alpha 2} \\ 0 & 1 & 0 & -X^{\alpha 3} & 0 & X^{\alpha 1} \\ 0 & 0 & 1 & X^{\alpha 2} & -X^{\alpha 1} & 0 \\ 0 & 0 & 0 & e_1^{\alpha 1} & e_1^{\alpha 2} & e_1^{\alpha 3} \\ 0 & 0 & 0 & e_2^{\alpha 1} & e_2^{\alpha 2} & e_2^{\alpha 3} \end{pmatrix}$$

where $X_\alpha^I$ is the initial coordinate of the node $\alpha$ on the subdomain I.

Now consider a movement represented by the affine transformation (a transformation characterized by mirroring a segment to another segment without any change of directed line segment ratio) for the defined movement of the subdomain I (referred to as affine transformation movement herein below).

This is the generalization of rigid motion discussed in the foregoing section, which is the combination of the translational motion and generalized linear transformation motion. $\mathbf{W}^I$ can be constructed in a practical sense as follows:

The affine transformation movement of the subdomain I can be expressed as follows. Define $\mathbf{X}_\alpha^I$ as the initial coordinate of the node $\alpha$ on the subdomain I, $\mathbf{x}_\alpha^I$ as the coordinate after transformation,

$$\text{eq 62} \qquad x_\alpha^I = P_j v^j + e^{E_j^e \alpha^j + E_j^s \varepsilon^j + 0_j \theta^j} X_\alpha^I$$

$$\text{eq 63} \qquad E_1^e \equiv \begin{pmatrix} 1 & & \\ & 0 & \\ & & 0 \end{pmatrix},\quad E_2^e \equiv \begin{pmatrix} 0 & & \\ & 1 & \\ & & 0 \end{pmatrix},\quad E_3^e \equiv \begin{pmatrix} 0 & & \\ & 0 & \\ & & 1 \end{pmatrix}$$

$$\text{eq 64} \qquad E_1^s \equiv \begin{pmatrix} 0 & & \\ & & 1 \\ & 1 & \end{pmatrix},\quad E_2^s \equiv \begin{pmatrix} & & 1 \\ & 0 & \\ 1 & & \end{pmatrix},\quad E_3^s \equiv \begin{pmatrix} & 1 & \\ 1 & & \\ & & 0 \end{pmatrix}$$

Or equations (65), (66), (67), and (68) below:

$$\text{eq 65} \qquad x_\alpha^I = P_j v^j + e^{E_{ij} \theta^{ij}} X_\alpha^I$$

$$\text{eq 66} \qquad E_{11} \equiv \begin{pmatrix} 1 & & \\ & 0 & \\ & & 0 \end{pmatrix},\quad E_{12} \equiv \begin{pmatrix} 0 & 1 & \\ & 0 & \\ & & 0 \end{pmatrix},\quad E_{13} \equiv \begin{pmatrix} 0 & & 1 \\ & 0 & \\ & & 0 \end{pmatrix}$$

$$\text{eq } 67 \qquad E_{21} \equiv \begin{pmatrix} 0 & & \\ 1 & 0 & \\ & & 0 \end{pmatrix}, \quad E_{22} \equiv \begin{pmatrix} 0 & & \\ & 1 & \\ & & 0 \end{pmatrix}, \quad E_{23} \equiv \begin{pmatrix} 0 & & \\ & 0 & 1 \\ & & 0 \end{pmatrix}$$

$$\text{eq } 68 \qquad E_{31} \equiv \begin{pmatrix} 0 & & \\ & 0 & \\ 1 & & 0 \end{pmatrix}, \quad E_{32} \equiv \begin{pmatrix} 0 & & \\ & 0 & \\ & 1 & 0 \end{pmatrix}, \quad E_{33} \equiv \begin{pmatrix} 0 & & \\ & 0 & \\ & & 1 \end{pmatrix}$$

Equations (69) and (70) when considering the micro-deformation.

$$\text{eq } 69 \qquad x_\alpha^I \cong P_j v^j + (1 + E_{ij}\theta^{ij}) X_\alpha^I$$

$$\text{eq } 70 \qquad u_\alpha^I \cong P_j v^j + E_{ij} X_\alpha^I \theta^{ij}, \qquad v \equiv \begin{pmatrix} v^1 \\ v^2 \\ v^3 \end{pmatrix}, \qquad \theta^{ij} \equiv \begin{pmatrix} \theta^{11} & \theta^{12} & \theta^{13} \\ \theta^{21} & \theta^{22} & \theta^{23} \\ \theta^{31} & \theta^{32} & \theta^{33} \end{pmatrix}$$

Now define $W^I$ in 12 dimension vector space having its base of twelve displacements $\{Z_j^I\}_{j=1,L,12}$ on the subdomain I defined by the following condition given by:

$$\text{eq } 71 \qquad \begin{aligned} Z_j^I &: \quad Z_j^I(X_\alpha^I) = P_j \\ Z_{3i+j}^I &: \quad Z_{3i+j}^I(X_\alpha^I) = E_{ij} X_\alpha^I \end{aligned}, \qquad i = 1, 2, 3, \qquad j = 1, 2, 3$$

then,

$$\text{eq } 72 \qquad W^I \equiv \left\{ \sum_{j=1}^{m^I} Z_j^I \mu^j \;\middle|\; \mu^j \in R \right\}, \qquad m^I \le 12$$

Equation 72 considers the following situation as similar to the case of rigid motion. Depending on subdomains, the degree of freedom of the affine transformation movement can be equal to or less than 11. In such a situation the number j of $Z^I$ should be renumbered such that the base becomes $\{Z_j^I\}_{j=1,L,m^I}$ $m^I \equiv \dim W^I \le 12$. Gram-Schmidt orthogonal method is used for renumbering of the number j.
Now the computation procedure in practice of the parallel finite element method solver according to the CGCG method will be described in greater details below.

   1. domain decomposition
      The domain subject to be analyzed is decomposed to a plurality of subdomains.

   2. distribution of subdomains to responsible part of processors
      The allocation of decomposed subdomains to each computing node (CPU) is determined. More specifically, each computing node (CPU) is responsible for one of or a plurality of subdomains. The entire subdomains processed by a node is referred to as a "part" (see Fig. 1).

3. creation of rigid matrix
A rigid matrix corresponding to the subdomain processed by a CPU is created.

4. setting of overlapped motion of entire subdomain

4.1. creation of projector displaying all degree of freedom
The base (the base of subspace can be considered as a projector to that subspace) of coarse space displaying all degree of freedom,

$$\mathbf{D^I Z^I} \equiv \left\{ \mathbf{D^I Z^I_j} \right\}_{j=1,L,m^I}$$

is created for each subdomain processed by a node, for extracting the overlapped motion of all subdomains.
4.2. creation of the matrix $\mathbf{K}_{rgd}$ of overlapped motion of all subdomains
the matrix of overlapped motion of all subdomains $\mathbf{K}_{rgd} = \mathbf{K}_{rgd}{}^{IJ} = \mathbf{D^I Z}_i^I \cdot \mathbf{KD^J Z}_j^J$ is formed. This computation can be conducted by determining the contribution from that subdomain at the node that maintains the rigid matrix $\mathbf{K^I}$ of subdomains, and summing all the contributions.
4.3. LU decomposition of the matrix $\mathbf{K}_{rgd}$ of overlapped motion of all subdomains
LU decomposition $\mathbf{K}_{rgd} = \mathbf{L}_{rgd} \mathbf{U}_{rgd}$ is executed on $\mathbf{K}_{rgd}$. The $\mathbf{L}_{rgd}$, $\mathbf{U}_{rgd}$ thus LU decomposed are kept in all of nodes.

5. Initial setting of projected CG method with preprocessing of all degree of freedom

5.1. initial displacement setting of all degree of freedom

5.1.1. overlapped movement of all subdomains $\mu^{(W)}$
Solve the following equation (73) for $\mu^{(W)}$:

$$\text{eq 73} \qquad K_{rgd}\mu^{(W)} = (NDZ)^T F$$

where

$$\mathbf{NDZ} \equiv \left\{ \mathbf{N^I D^I Z^I_j} \right\}_{j=1,L,m^I_I} \cdot \quad \mathbf{F}$$

is kept by the node with respect to the responsible part, and the nodes will communicate each other after solving $(\mathbf{NDZ})^T\mathbf{F}$ to create the right side vector of entire domain, and uses $\mathbf{K}_{rgd}$ that has LU decomposed by all nodes to determine $\mu^{(W)}$. The term corresponding to $\mathbf{u}^{(W)}$ of equation (10) will be $\mathbf{u}^{(W)} = \mathbf{NDZ}\mu^{(W)}$.

5.1.2. setting of initial displacement $\mathbf{u}_0$
Initial displacement $\mathbf{u}_0$ is set according to equation (74) below:

$$\text{eq 74} \qquad u_0 = NDZ\mu^{(W)}$$

$\mathbf{u}_0$ is kept by each node for their responsible part.

5.2. computation of initial residual error $\mathbf{g}_0$ of all degree of freedom
Initial residual error $\mathbf{g}_0$ will be determined according to equation (75) below:

$$\text{eq 75} \qquad g_0 = Ku_0\text{-}F$$

This residual vector is held by each node for their responsible part. Note here that the sign is inverted with respect to the residual error $\mathbf{r}_{(a)_n}$ discussed by referring to equations (14) to (16).

5.3. computation of diagonal scaling preprocessing
Determine $\mathbf{D}_K^{-1}\mathbf{g}_0$ for the residual error $\mathbf{g}_0$ (this is the diagonal scaling preprocessing). $\mathbf{D}_K^{-1}$ is the inverse matrix of $\mathbf{D}_K$, $\mathbf{D}_K$ is the diagonal matrix of $\mathbf{K}$ (diagonal matrix which has diagonal components equal to the diagonal components of $\mathbf{K}$). Eachnode solves this for their responsible part.

5.4. computation of coarse grid preprocessing of all degree of freedom
Coarse grid preprocessing $\mathbf{P}^{(a)}\mathbf{G}\mathbf{g}_0 = \overline{\mathbf{G}}\mathbf{g}_0$ is executed as follows:

5.4.1. overlapped motion variable for all subdomains $\mu^{(W)}$
Solve the following equation (76) for $\mu^{(W)}$ :

$$\text{eq 76} \qquad K_{rgd}\mu^{(W)} = \text{-}(NDZ)^T KD_K^{-1}g_0$$

where right side vector is created by all nodes communicating each other for the entire domain, and all nodes solve $\mu^{(W)}$.

5.4.2. setting $\mu^{(W)}$
setting $\mu_0^{(W)}$ according to equation (77)

$$\text{eq 77} \qquad \mu_0^{(W)} = NDZ\mu^{(W)}$$

$\mu_0^{(W)}$ is held for the responsible part.

5.4.3. computation of $\mathbf{P}^{(a)}\mathbf{G}\mathbf{g}_0 = \overline{\mathbf{G}}\mathbf{g}_0$
$\overline{\mathbf{G}}\mathbf{g}_0$ is computed according to equation (78) below:

$$\text{eq 78} \qquad \overline{G}g_0 = \mu_0^{(W)} + D_K^{-1}g_0$$

This can be solved for the responsible part.

5.5. setting of initial vector value $\mathbf{w}_0$ in the search direction of the CG method of all degree of freedom
Initial vector value $\mathbf{w}_0$ in the search direction of the CG method of all degree of freedom will be set according to equation (79) below:

$$\text{eq 79} \qquad w_0 = \overline{G}g_0$$

This can be solved for the responsible part.

6. Iterative computation by the projected CG method with preprocessing of all degree of freedom

6.1. displacement update of all degree of freedom
For $n \geq 1$, displacement of all degree of freedom $\mathbf{u}_{n-1}$ is updated according to the following procedure.

6.1.1. computation of $\mathbf{Kw}_{n-1}$
$\mathbf{Kw}_{n-1}$ is determined for the responsible part.

6.1.2. computation of $\alpha_n$
All nodes communicating each other will determine $\alpha_n$ according to equation (80).

$$\text{eq 80} \qquad \alpha_n = \frac{g_{n-1} \cdot \overline{G} g_{n-1}}{w_{n-1} \cdot K w_{n-1}}$$

### 6.1.3. update of the responsible part of $\mathbf{u}_{n-1}$

The responsible part of $\mathbf{u}_{n-1}$ will be updated according to equation (81).

$$\text{eq 81} \qquad u_n = u_{n-1} - \alpha_n w_{n-1}$$

### 6.2. update of residual error of all degree of freedom

For $n \geq 1$, the responsible part of residual error $\mathbf{g}_{n-1}$ of all degree of freedom will be updated according to equation 82.

$$\text{eq 82} \qquad g_n = g_{n-1} - \alpha_n K w_{n-1}$$

### 6.3. computation of diagonal scaling preprocessing $\mathbf{D}_K^{-1} \mathbf{g}_n$

Similar to 5.3., each node will solve $\mathbf{D}_K^{-1} \mathbf{g}_n$ for the residual error $\mathbf{g}_n$ for their respective responsible part (diagonal scaling preprocessing).

### 6.4. computation of coarse grid preprocessing $\overline{\mathbf{G}} \mathbf{g}_n$ of all degree of freedom

Using the same procedure as 5.4., $\overline{\mathbf{G}} \mathbf{g}_n$ will be determined for the responsible part. More specifically, two equations (83) and (84) will be solved to form equation (85).

$$\text{eq 83} \qquad K_{rgd} \mu^{(W)} = -(NDZ)^T K D_K^{-1} g_n$$

$$\text{eq 84} \qquad \mu_n^{(W)} = NDZ \mu^{(W)}$$

$$\text{eq 85} \qquad \overline{G} g_n = \mu_n^{(W)} + D_K^{-1} g_n$$

### 6.5. update of vector $\mathbf{w}_{n-1}$ of search direction of the CG method of all degree of freedom

$\mathbf{w}_{n-1}$ will be update according to the following procedure.

### 6.5.1. computation of $\beta_n$

$\beta_n$ will be determined by all nodes communicating each other according to equation (86).

$$\text{eq 86} \qquad \beta_n = \frac{g_n \cdot \overline{G} g_n}{g_{n-1} \cdot \overline{G} g_{n-1}}$$

### 6.5.2. update of $\mathbf{w}_{n-1}$

$\mathbf{w}_{n-1}$ will be updated for the responsible part according to equation (87):

$$\text{eq 87} \qquad w_n = \overline{G} g_n + \beta_n w_{n-1}$$

### 6.6. determining convergence

The convergence will be determined from the updated residual error $\mathbf{g}_n$. If not convergent, then the procedure will go back to step 6.1. to repeat the steps that follow.

### 7. output of displacement solution $\mathbf{u}$

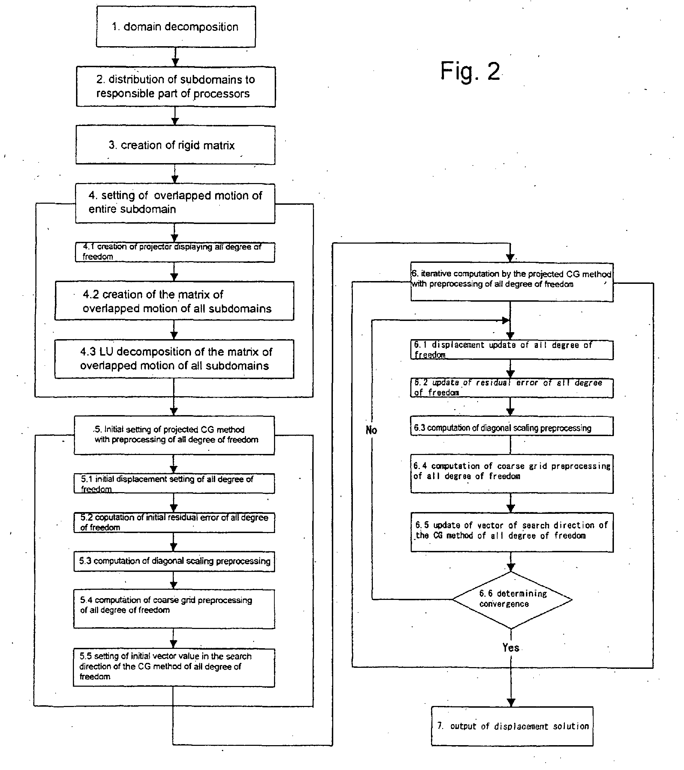

$\mathbf{u}_n$ at the time of convergence of the CG method with preprocessing is set to displacement solution $\mathbf{u}$. Any strain and stress maybe derived from $\mathbf{u}$ if needed. This computational procedure is shown in Fig. 2.

[Preferred Embodiment]

The superiority of computing performance of CGCG method over the DDM, parallel CG method, and BDD method will be described with reference to an embodiment. In this embodiment the computing performance of finite element method with a bogie model will be compared. This model includes tetrahedral first order element, 323, 639 nodes, 1,123,836 elements, 970, 911 degrees of freedom (constrained only 6 degrees of freedom). The computing environment was : four dual Pentium III processors 600 MHz machines, four PEs (one process for each machine). The computing conditions were: the CG method tolerance $1.0*10^{-6}$. The comparison of computing performance is shown in Table 1. From Table 1 one can conclude that the CGCG method has a significantly fewer number of iterative steps and significantly shorter time of computation, in comparison with the DDM and the proj ected CG method. Although the number of iterative steps of the CGCG method is greater than the BDD method, the computing speed is almost three folds of the BDD method.

Table 1

| Method | subdomains | iterative steps | time (minutes ) | memory usage (MB/PE) |
|---|---|---|---|---|
| CGCG method | 1,600 | 599 | 15 | 167 |
| parallel CG method | 4 | 28,565 | 201 | 90 |
| DDM | 12,000 | 20,358 | 377 | 167 |
| BDD method | 2,400 | 293 | 40 | 440 |

Example 1

Although the comparison with the DDM with Neumann preprocessing is not listed in Table 1, there are a computing example of the comparison of computing performance of the DDM with that of the DDM with Neumann preprocessing. The computing performance of this example is shown in Table 2. This example used a simplified model made by combining a plurality of rectangular parallelepipeds, which includes tetrahedral second order element, 1,029 nodes, 504 elements, 3,087 degrees of freedom (bottom surface completely immobilized and top suraface forcibly displaced). The computing environment was: one Alpha21164 600MHz machine, one PE, and the computing conditions were the CG method tolerance of $1.0*10^{-7}$. Table 2 shows the computing time and the number of iterative steps of the DDM and the DDM with Neumann preprocessing. The time saved by the DDM with Neumann preprocessing is approximately 13%, the number saved of iterative steps is at most approximately 1/2. From this example 1 and the preferred embodiment, the CGCG method in accordance with the present invention is characterized by significantly shorter computation time, in comparison with the DDM, the projected CG method, and the DDM with Neumann preprocessing, which are known in the art as the solutions of a very large scaled structure problem, and by significantly faster computing in comparison with the BDD method, which was developed for the purpose of improved speed and robustness. It can be seen that the number of iterative steps may be even greater than the BDD method, but considerably fewer in comparison with the DDM, the projected CG method and the DDM with Neumann preprocessing. The CGCG method has a very high potential in the computing performance for the solution of very large scaled structure problem.

Table 2

| Method | Subdomains | Iterative steps | Computing time |
|---|---|---|---|
| DDM | 12 | 420 | 480 |
| DDM with Neumann preprocessing | 12 | 240 | 420 |

EFFECTS OF THE INVENTION

As can be seen from the foregoing, the CGCG method is a finite element method solver algorithm which effectively solves a large scale problem, and is applicable to any analysis based on the finite element method. For example, the method can be applicable 'to the problems in the field of continuum dynamics, solid dynamics, structure theory, hydrodynamics, thermal conduction theory, and electromagnetics, formulated by the finite element method. In addition, the finite element method can be considered to be a generalized solution of boundary value problem in which the differential equation is the dominant equation, then the CGCG method may be applicable as the solution of boundary value problems in general, in which the differential equation is the dominant equation. In any problems the applied CGCG method is effective for efficiently solving a large scaled problem. The CGCG method may significantly save time in the computation in comparison with the DDM, the projected CG method, and the DDM with Neumann preprocessing, all of which are known in the art as the finite element method solver algorithms for solving a large scaled problem, and also significantly save the number of computational iterative steps.

In addition, the CGCG method is potentially higher performer in comparison with the BDD method, which was developed for accelerating the computation.

**Claims**

1. A parallel finite element method computing system for solving a very large scaled structure problem having the degree of freedom of one million (1,000,000) or more, comprising:

    a means for performing domain decomposition;
    a means for distributing a subdomain to a responsible part of each processor;
    a means for creating a rigid matrix;
    a means for defining overlapped movement of entire subdomain;
    a means for defining a default setting of projected CG. method with preprocessing of all degree of freedom;
    a means for performing iterative computation of projected CG method with preprocessing of all degree of freedom; and
    a means for outputting a displacement solution.

2. A parallel finite element method computing system set forth in claim 1, in which said means for defining overlapped movement of entire subdomain may further comprise:

    a means for creating a projector for displaying all degree of freedom;
    a means for creating an overlapped movement matrix of entire subdomain; and
    a means for LU decomposing said overlapped movement matrix of entire subdomain.

3. A parallel finite element method computing system set forth in claim 1, in which said means for defining a default setting of projected CG method with preprocessing of all degree of freedom may further comprise:

    a means for setting initial displacement of all degree of freedom;
    a means for performing computation of initial residual error of all degree of freedom;
    a means for performing computation of diagonal scaling preprocessing;
    a means for performing computation of coarse grid preprocessing of all degree of freedom; and
    a means for defining an initial vector value in the search direction of CG method with all degree of freedom.

4. A parallel finite element method computing system set forth in claim 1, in which said means for performing iterative computation of projected CG method with preprocessing of all degree of freedom may further comprise:

    a means for updating the displacement of all degree of freedom;
    ameans for updating the residual error of all degree of freedom;
    a means for performing computation of diagonal scaling preprocessing;
    a means for performing computation of coarse grid preprocessing of all degree of freedom;
    a means for updating vectors in the search direction of CG method of all degree of freedom; and
    a means of determining the convergence.

5. A parallel finite element method computing program used in a parallel finite element method computing system for solving a very large scaled structure problem having the degree of freedom of one million (1,000,000) or more, **characterized in that** said program operates as
    a means for performing domain decomposition;
    a means for distributing a subdomain to a responsible part of each processor;
    a means for creating a rigid matrix;
    a means for defining overlapped movement of entire subdomain;
    a means for defining a default setting of projected CG method with preprocessing of all degree of freedom;
    a means for performing iterative computation of projected CG method with preprocessing of all degree of freedom; and

a means for outputting a displacement solution,

**6.** A parallel finite element method computing program set forth in claim 5, in which said means for defining overlapped movement of entire subdomain may further operate as
a means for creating a projector for displaying all degree of freedom;
a means for creating an overlapped movement matrix of entire subdomain; and
a means for LU decomposing said overlapped movement matrix of entire subdomain;

**7.** A parallel finite element method computing program, set forth in claim 5, in which said means for defining a default setting of projected CG method with preprocessing of all degree of freedom may further operate as
a means for setting initial displacement of all degree of freedom;
a means for performing computation of initial residual error of all degree of freedom;
a means for performing computation of diagonal scaling preprocessing;
a means for performing computation of coarse grid preprocessing of all degree of freedom; and
a means for defining an initial vector value in the search direction of CG method with all degree of freedom;

**8.** A parallel finite element method computing program, set forth in claim 5, in which said means for performing iterative computation of projected CG method with preprocessing of all degree of freedommay further operate as
a means for updating the displacement of all degree of freedom;
a means for updating the residual error of all degree of freedom;
a means for performing computation of diagonal scaling preprocessing;
a means for performing computation of coarse grid preprocessing of all degree of freedom;
a means for updating vectors in the search direction of CG method of all degree of freedom; and
a means of determining the convergence.

**9.** A computer readable recording medium having stored thereon a parallel finite element method computing program used in a parallel finite element method computing system for solving a very large scaled structure problem having the degree of freedom of one million (1,000,000) or more, **characterized in that** said program operates as
a means for performing domain decomposition;
a means for distributing a subdomain to a responsible part of each processor;
a means for creating a rigid matrix;
a means for defining overlapped movement of entire subdomain;
a means for defining a default setting of projected CG method with preprocessing of all degree of freedom;
a means for performing iterative computation of projected CG method with preprocessing of all degree of freedom; and
a means for outputting a displacement solution.

**10.** A computer readable recording medium having stored thereon a parallel finite element method computing program set forth in claim 9, in which said means for defining overlapped movement of entire subdomain may further operate as
a means for creating a projector for displaying all degree of freedom;
a means for creating an overlapped movement matrix of entire subdomain; and
a means for LU decomposing said overlapped movement matrix of entire subdomain.

**11.** A computer readable recording medium having stored thereon a parallel finite element method computing program set forth in claim 9, in which said means for defining a default setting of projected CG method with preprocessing of all degree of freedom may further operate as
a means for setting initial displacement of all degree of freedom;
a means for performing computation of initial residual error of all degree of freedom;
a means for performing computation of diagonal scaling preprocessing;
a means for performing computation of coarse grid preprocessing of all degree of freedom; and
a means for defining an initial vector value in the search direction of CG method with all degree of freedom.

**12.** A computer readable recording medium having stored thereon a parallel finite element method computing program, set forth in claim 9, in which said means for performing iterative computation of projected CG method with preprocessing of all degree of freedom may further operate as
a means for updating the displacement of all degree of freedom;
a means for updating the residual error of all degree of freedom;

a means for performing computation of diagonal scaling preprocessing;
a means for performing computation of coarse grid preprocessing of all degree of freedom;
a means for updating vectors in the search direction of CG method of all degree of freedom; and
a means of determining the convergence.

## Fig. 1

entire domain

sub 1          sub 2          sub3

one of subdomains

Fig. 2

1. domain decomposition

2. distribution of subdomains to responsible part of processors

3. creation of rigid matrix

4. setting of overlapped motion of entire subdomain

4.1 creation of projector displaying all degree of freedom

4.2 creation of the matrix of overlapped motion of all subdomains

4.3 LU decomposition of the matrix of overlapped motion of all subdomains

5. Initial setting of projected CG method with preprocessing of all degree of freedom

5.1 initial displacement setting of all degree of freedom

5.2 coputation of initial residual error of all degree of freedom

5.3 computation of diagonal scaling preprocessing

5.4 computation of coarse grid preprocessing of all degree of freedom

5.5 setting of initial vector value in the search direction of the CG method of all degree of freedom

6. iterative computation by the projected CG method with preprocessing of all degree of freedom

6.1 displacement update of all degree of freedom

6.2 update of residual error of all degree of freedom

6.3 computation of diagonal scaling preprocessing

6.4 computation of coarse grid preprocessing of all degree of freedom

6.5 update of vector of search direction of the CG method of all degree of freedom

6.6 determining convergence

No

Yes

7. output of displacement solution

27

## INTERNATIONAL SEARCH REPORT

International application No.

PCT/JP02/04617

| A. CLASSIFICATION OF SUBJECT MATTER |
|---|
| Int.Cl$^7$ G06F17/13, G06F15/16, G06F17/50, G01M19/00 |

According to International Patent Classification (IPC) or to both national classification and IPC

**B. FIELDS SEARCHED**

| Minimum documentation searched (classification system followed by classification symbols) |
|---|
| Int.Cl$^7$ G06F17/10-17/18, G06F15/16-15/177, G06F17/50, G06F17/60-19/00, G01M13/00, G01M19/00 |

Documentation searched other than minimum documentation to the extent that such documents are included in the fields searched

| Jitsuyo Shinan Koho | 1922-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | Hiroshi AKIBA, Koichiro ISHIHARA, Shinobu YOSHIMURA, Ryuji SHIOTANI, "PC Cluster o Mochiita 1100-man Jiyudo Tetsudo Daisha Model no Shosai Oryoku Kaiseki", Dai 10-kai Design & Systems Conference, [online], 2001. 01, pages 84 to 87, [Retrieval date 13 August, 2002 (13.08.02)], Internet <URL:http://www.albe.co.jp/paper/jsme10ds200101.pdf> | 1-12 |
| A | Ryuji SHIOTANI, Motoki YAGAWA, "Hanpuku Kaiho o Mochiita Ryoiki Bunkatsugata FEM", The Japan Society of Mechanical Engineers, Dai 6-kai The Computational Mechanics Conference, 10 November, 1993 (10.11.93), pages 23 to 24 | 1-12 |

☒ Further documents are listed in the continuation of Box C. ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 August, 2002 (13.08.02) | 03 September, 2002 (03.09.02) |

| Name and mailing address of the ISA/ | Authorized officer |
|---|---|
| Japanese Patent Office | |
| Facsimile No. | Telephone No. |

Form PCT/ISA/210 (second sheet) (July 1998)

28

**INTERNATIONAL SEARCH REPORT**

| International application No. |
|---|
| PCT/JP02/04617 |

C (Continuation).   DOCUMENTS CONSIDERED TO BE RELEVANT

| Category* | Citation of document, with indication, where appropriate, of the relevant passages | Relevant to claim No. |
|---|---|---|
| A | Osamu TATEBE, MGCG METHOD: A ROBUST AND HIGHLY PARALLEL ITERATIVE METHOD, doctoral thesis, The Graduate School of The University of Tokyo, [online], March 1997, [retrieved on 2002-08-13], Retrieved from the Internet: <URL:http://phase.hpcc.jp/people/tatebe/research/paper/PhD-tatebe.ps.gz> | 1-12 |
| A | Ronny Mertens, Herbert De Gersem, Ronnie Belmans, Kay Hameyer, Domenico Lahaye, Stefan Vandewalle, Dirk Roose, An Algebraic Multigrid Method for Solving Very large Electromagnetic Systems, IEEE TRANSACTIONS ON MAGNETICS, September 1998, Vol.34, No.5, pages 3327 to 3330 | 1-12 |

Form PCT/ISA/210 (continuation of second sheet) (July 1998)